(19) **Europäisches Patentamt**
**European Patent Office**
**Office européen des brevets**

(11) **EP 2 280 295 A1**

(12) **EUROPÄISCHE PATENTANMELDUNG**

(43) Veröffentlichungstag:
**02.02.2011 Patentblatt 2011/05**

(21) Anmeldenummer: **10012478.3**

(22) Anmeldetag: **06.03.2006**

(51) Int Cl.:
**G02B 1/02** $^{(2006.01)}$ **G02B 13/14** $^{(2006.01)}$
**C30B 29/22** $^{(2006.01)}$ **C30B 29/28** $^{(2006.01)}$
**G03F 7/20** $^{(2006.01)}$

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **08.03.2005 DE 102005010655**
**30.08.2005 DE 102005041119**
**02.09.2005 DE 102005041839**
**01.02.2006 DE 102006004904**
**02.09.2005 US 714091 P**

(62) Dokumentnummer(n) der früheren Anmeldung(en) nach Art. 76 EPÜ:
**06004496.3 / 1 701 179**

(71) Anmelder: **SCHOTT AG**
**55122 Mainz (DE)**

(72) Erfinder:
• **Wehrhan, Gunther, Dr.**
**07749 Jena (DE)**

• **Martin, Regina**
**07745 Jena (DE)**
• **Parthier, Lutz, Dr.**
**14532 Kleinmachnow (DE)**
• **Staeblein, Joerg**
**07743 Jena (DE)**
• **Letz, Martin, Dr.**
**55128 Mainz (DE)**
• **Alkemper, Jochen, Dr.**
**55270 Klein-Winternheim (DE)**
• **Knapp, Konrad**
**07743 Jena (DE)**
• **Petermann, Klaus, Dr.**
**22880 Wedel (DE)**

(74) Vertreter: **Fritzsche, Thomas**
**Fritzsche Patent**
**Naupliastrasse 110**
**81545 München (DE)**

(54) **Verfahren zur Herstellung von optischen Elementen für die Mikrolithographie, damit erhältliche Linsensysteme und deren Verwendung**

(57) Es wird die Verwendung von kubischen Granaten, kubischen Spinellen, kubischen Perovskiten und kubischen M(II)- sowie M(IV)-Oxiden zur Herstellung von optischen Elementen für die ultraviolette Strahlung beschrieben. Zweckmäßige Kristalle sind $Y_3Al_5O_{12}$, $Lu_3Al_5O_{12}$, $Ca_3Al_2Si_3O_{12}$, $K_2NaAlF_6$, $K_2NaScF_6$, $K_2LiAlF_6$ und/oder $Na_3Al_2Li_3F_{12}$, $(Mg,Zn)Al_2O_4$, $CaAl_2O_4$, $CaB_2O_4$ und/oder $LiAl_5O_8$ sowie $BaZrO_3$ und/oder $CaCeO_3$. Ein bevorzugtes optisches Element ist eine Frontlinse in einer Immersionsoptik für die Mikrolithographie für Wellenlängen unter 200 nm.

EP 2 280 295 A1

**Beschreibung**

Die Erfindung betrifft ein Verfahren zur Herstellung von optischen Elementen für die Mikrolithographie, sowie damit erhältliche Optiken und deren Verwendung zur Herstellung elektronischer Bauteile.

In einer elektronischen Rechen- oder Steuereinheit werden sehr viele Schaltkreise auf engstem Raume angeordnet. Diese werden auch als integrierte Schaltkreise (IC) oder als Chip bezeichnet. Dabei sind durch raffinierte Anordnungen Schaltkreise möglich, die viele Millionen von Schaltfunktionen durchführen können. Durch die permanente Erhöhung der Rechen- bzw. Schaltfunktionen solcher Schaltkreise wird ihre Anordnung auf engstem Raum, d. h. ihre Packdichte immer größer. So soll bei regelmäßiger Verkleinerung solcher Chips gemäß dem sog. Moore'schen Gesetz sich die Rechenleistung bzw. die Rechengeschwindigkeit solcher Schaltkreise alle 18 bis 24 Monate verdoppeln. Um dies zu erreichen, ist es nötig, Transistoren für derartige Rechen- bzw. Schaltkreise immer weiter zu verkleinern und immer enger neben- sowie übereinander anzuordnen. Nur auf diese Weise lässt sich die Miniaturisierung, die Wärmeentwicklung, und damit auch die Rechengeschwindigkeit permanent verringern.

Derartige miniaturisierte Schaltkreise werden durch die sog. Mikrolithographie hergestellt, bei der ein lichtempfindlicher Lack, ein sog. Fotoresist, mittels einer aufwändigen Optik mit Licht belichtet wird. Auf diese Weise lassen sich Abbildungen von zuvor entworfenen Leiterbahnen und Schaltkreisen auf dem Fotolack erzeugen und durch eine weitere Behandlung aus dieser Abbildung ein gesamtes Netzwerk von integrierten Schaltkreisen herstellen. Dabei hängt die Verkleinerung der Schaltkreise auch von der jeweiligen Wellenlänge des verwendeten Lichtes ab. Derzeit werden hierzu Belichtungswellenlängen im UV, insbesonders im tiefen UV-Bereich verwendet. Insbesondere wird hierzu kohärentes Licht, d. h. Laserlicht, und zwar Excimerlaser verwendet, wie beispielsweise KrF-Laser mit einer Wellenlänge von 248 nm, ArF-Laser mit einer Wellenlänge von 193 nm, und $F_2$-Laser mit einer Wellenlänge von 157 nm. Auf diese Weise ist es möglich, Chipstrukturen mit einer Breite von weniger als 100 nm herzustellen.

Für eine Verkleinerung der Chipstrukturen ist es jedoch nicht nur notwendig, die Wellenlänge des Belichtungslasers zu verkleinern, sondern es muss auch die Abbildungsgenauigkeit der gesamten Belichtungsoptik verbessert werden, d. h. die Auflösung der Optik zu verbessern.

Aus der Mikroskopietechnik ist es nun bekannt, dass das Auflösungsvermögen von Optiken durch Verwendung einer sog. Immersionsflüssigkeit, die zwischen dem Objekt und dem Objektiv angeordnet wird, drastisch verbessert werden kann. Es sind daher bereits Immersionsvorsätze für kommerziell erhältliche Lithographiegeräte entwickelt worden (z. B. Twinscan™ von ASML), sowie erste vollfunktionsfähige Lithographiegeräte, welche jedoch noch konventionelle Linsensysteme enthalten.

So beschreibt beispielsweise J. H. Burnett et al. in "High Index Materials for 193 nm and 157 nm Immersion Lithography", International Symposium on Immersion and 157 nm Lithography, Vancouver, 8/2/04, die Verwendung von hochbrechenden Materialien als Linsensystem in der Immersionsfotolithographie. Danach soll der Brechungsindex zur Erreichung einer maximalen numerischen Apertur bei einer vorgegebenen Wellenlänge wesentlich größer als derjenige von Wasser sein. Daher schlagen Burnett et al vor, die Erdalkalifluoride $CaF_2$, $SrF_2$ und/oder $BaF_2$ zu verwenden, die für die Wellenlänge 193 nm einen absoluten Brechungsindex von 1,5 bis 1,58 bzw. für 157 nm von 1,56 bis 1,66 aufweisen. Des weiteren werden Mischkristalle der allgemeinen Formel $Ba_xSr_{1-x}F_2$ und $Ba_xCa_{1-x}F_2$ für x gleich 0 bis 1 und $Ba_xCa_{1-x}F_2$ mit x ungefähr 0,1 vorgeschlagen. Auch Erdalkalioxide wie MgO, CaO, SrO und BaO werden als mögliche Linsenmaterialien angeführt. Dabei wird auch beschrieben, dass es prinzipiell auch möglich ist, durch Mischen dieser Oxide die intrinsische Doppelbrechung zu kompensieren, wobei insbesondere CaO die Doppelbrechung kompensieren kann und gleichzeitig den Brechungsindex erhöht.

Es hat sich jedoch gezeigt, dass sich mit diesen vorgeschlagenen Materialien mittels den bekannten Techniken nur schwer aus Schmelzen großvolumige Einkristalle züchten lassen, welche die zur Herstellung von derartigen Linsen nötige Homogenität erreichen. Darüber hinaus sind die Phasendiagramme für Zusammensetzungen, die zur Erzielung von hohen Brechzahlen notwendig sind, äußerst kritisch und zeigen mit den bekannten Kristallzuchttechniken schwer realisierbare Schmelzpunkte auf. Schließlich wird in solchen Mischungsverhältnissen auch keine ausreichende optische Homogenität erreicht.

Die Erfindung hat daher zum Ziel, Linsen bzw. Linsensysteme bereit zu stellen, die bei den genannten Wellenlängen eine hohe Auflösung bzw. hohe Abbildungsschärfe ermöglichen und die insbesonders für die Immersionsmikrolithographie geeignet sind. Dabei sollen derartige Materialien optisch isotrop sein, sich mittels gängigen Verfahren aus einer Schmelze zu großen einkristallinen Körpern in Dimensionen von mindestens 150 mm auf 100 mm herstellen lassen, wobei die optischen Eigenschaften entsprechend der Kristallmaterialien bei einer Wellenlänge von 193 nm eine Spannungsdoppelbrechung kleiner 1 nm/cm, eine Homogenität $\Delta n$ kleiner 1 ppm und eine Absorption bei 193 nm von kleiner/gleich $2 \times 10^{-3}$ cm$^{-1}$ aufweisen sollen, wobei $K_{ini}$ den spektralen Absorptionskoeffizienten (initiale Absorption) bei der Einsatzwellenlänge (hier 193 nm) in cm$^{-1}$, beispielsweise bei einer Schichtdicke von 100 mm bedeutet. Schließlich sollen sich derartige Materialien möglichst schlierenfrei und einschlussfrei herstellen lassen.

Dieses Ziel wird durch die in den Ansprüchen definierten Merkmale erreicht.

Es wurde nämlich gefunden, dass Einkristalle aus kubischen Granaten, kubischen Spinellen, kubischen Perovskiten und/oder kubischen II/IV-Oxiden zur Herstellung von derartigen Linsen sowie optischen Systemen geeignet sind. Diese Substanzklassen lassen sich mittels den bekannten Zuchtverfahren aus der Schmelze herstellen, wie beispielsweise dem Bridgman-Stockbarger-Verfahren, dem Vertical-Gradient-Freeze-Verfahren sowie dem Czochralski-Verfahren oder auch dem Nacken-Kyropoulos-Verfahren. Alle Verfahren sind Verfahren, bei denen die Kristalle durch kontrolliertes Erstarren einer Schmelze gezüchtet werden. Alternativ ist auch eine Herstellung über die sogenannte Sol-Gel-Technik denkbar.

Ebenso ist es möglich, die angeführten Substanzklassen über ein Sintern von Nanopartikeln als sogenannte Optokeramiken herzustellen, wobei aufgrund der statistischen Orientierungsverteilung der Nanokristalle keine intrinsche Doppelbrechung mehr auftritt. Bei herkömmlichen Optokeramiken wird versucht, durch den Sinterprozess Materialien mit einer relativ großen Kristallitgröße bzw. Korngröße herzustellen, insbesondere weisen solche herkömmliche Optokeramiken eine Kristallitgröße, d.h. einen Durchmesser der Kristallite im Bereich von etwa 10 bis 100 $\mu$m auf. Auch wenn zur Herstellung solcher herkömmlicher Optokeramiken Ausgangspulver mit einem Durchmesser im nm-Bereich verwendet werden, wird das Sinterverfahren so gesteuert, dass ein Wachstum der Kristallite bis zu der vorstehend genannten Größe stattfindet. Gemäß einer Ausführungsform der Erfindung ist es jedoch bevorzugt, Optokeramiken mit einer Kristallitgröße von höchstens 100 nm, vorzugsweise höchstens 30 nm und am meisten bevorzugt von höchstens 20 nm zu verwenden. Gemäß einer besonderen Ausführungsform beträgt die Kristallitgröße höchstens ein Zehntel der Wellenlänge des eingestrahlten Lichts, d.h. bei einer Wellenlänge von 193 nm beträgt die Kristallitgröße höchstens etwa 20 nm. Es hat sich herausgestellt, dass sich Optokeramiken mit einer solchen kleinen Kristallitgröße am besten für die Mikrolithographie eignen. Bei den in der Mikrolithographie verwendeten kleinen Beleuchtungswellenlängen von weniger als 300 nm, vorzugsweise weniger als 200 nm weisen optokeramische Materialien mit einer größeren Kristallitgröße durch die zufällige bzw. statistische Orientierung der einzelnen Kristallite und die ortsunabhängige Fluktuation des Brechungsindex eine zu hohe Streuung durch die intrinsische Doppelbrechung auf. Weiterhin ist daher bevorzugt, dass Optokeramiken eine möglichst homogene Kristallitgrößenverteilung aufweisen, insbesondere beträgt die Standardabweichung $\Delta r/r$ mit höchstens 50 %, vorzugsweise höchstens 20 % am meisten bevorzugt höchstens 5 %, wobei r der Radius der Kristallite ist und die Gleichung

$$\Delta r = \sqrt{\overline{r}^{\,2} - \overline{r^2}}$$

gilt.

Unter den kubischen Granaten sind insbesonders Yttrium-Aluminium-Granat $Y_3Al_5O_{12}$, Lutetium-Aluminium-Granat (LuAG) $Lu_3Al_5O_{12}$, Grossular $Ca_3Al_2Si_3O_{12}$, Elpasolith $K_2NaAlF_6$, $K_2NaScF_6$, $K_2LiAlF_6$ und/oder Kryolithionit $Na_3Al_2Li_3F_{12}$ besonders geeignet. Weitere geeignete Granate sind $Tm_3Al_5O_{12}$, $Sc_3Al_5O_{12}$, $Dy_3Al_5O_{12}$, sowie $YbAl_5O_{12}$.

Die Erfindung betrifft auch optische Elemente vom Typ der kubischen Granate, wie den zuvor erwähnten $Y_3Al_5O_{12}$ (YAG) bzw. $Lu_3Al_5O_{12}$ (LuAG) in denen das Yttrium bzw. Lutetium ganz oder teilweise durch Ionen der gleichen Valenz und mit vergleichbaren Ionenradien ersetzt sind. Es hat sich nämlich gezeigt, dass durch eine derartige ganze oder teilweise Substitution die Absorptionskante die bei $Y_3Al_5O_{12}$ bei ca. 185 nm liegt, verschoben werden kann. Da die Arbeitswellenlänge eines ArF-Lithographie Steppers bei 193 nm bereits in der Nähe der Absorptionskante liegt, findet bereits hier eine wenn auch tolerierbare Verringerung der Transmission statt. Bislang wurden bei kubischen Granaten wie vom $Y_3Al_5O_{12}$ (YAG) nur Transmissionswerte von ca. 50% erreicht worden sind. Durch die Dotierung bzw. Substitution ist es möglich die Absorptionskante weiter im kurzwelligen Bereich zu verschieben. Dabei ist es erfindungsgemäß bevorzugt den Kristallen solche Elemente und diese in einer solchen Konzentration zuzumischen, dass die Verschiebung mindestens 5 nm, vorzugsweise mindestens 8, insbesondere mindestens 10 nm beträgt. Voraussetzung ist es jedoch, dass die zudotierten Elemente keine zusätzliche Absorptions- oder Emissionsbande im Bereich der Arbeitswellenlängen, insbesondere im Bereich 193 nm +/- 10 nm aufweisen, und dadurch die Transmission unter den geforderten Wert verringern. Selbstverständlich ist auch bevorzugt solche Dotierungsmittel zu verwenden, welche sich gut im fertigen Kristall lösen, bzw. einmischen lassen.

Die Erfindung betrifft daher optische Elemente, die aus kubischen Granaten der allgemeinen Formel

$$(A_{1-x}D_x)_3Al_5O_{12}$$

bestehen, wobei D ein mit $A^{3+}$ bezüglich Valenz und Ionenradius ähnliches Element ist, um die Gitterverzerrungen so gering wie möglich zu erhalten. Erfindungsgemäß bevorzugte Elemente A sind insbesondere Yttrium, seltene Erden bzw. Lanthanide, d. h. Ce, Pr, Nd, Pm, Sm, Eu, Gd, Tb, Dy, Ho, Er, Tm, Yb, und/oder Lu, sowie Scandium, wobei die Elemente Y, Lu, Yb, Tm, und Dy sowie Sc besonders bevorzugt sind. Geeignete Vertreter des Dotierungsmittels D sind ebenfalls ausgewählt aus der Gruppe umfassend Yttrium, seltene Erden, sowie Scandium. Als besonders zweckmäßig haben sich mit anderen seltenen Erden und/oder Sc dotierte Granate vom Typ $Y_3Al_5O_{12}$, $Lu_3Al_5O_{12}$, $Dy_3Al_5O_{12}$,

$Tm_3Al_5O_{12}$, $Yb_3Al_5O_{12}$, erwiesen und speziell ein Mischkristall aus $(Y_{1-x}Lu_x)_3Al_5O_{12}$.

x bedeutet den Molenbruch mit $0 \leq x \leq 1$. Vorzugsweise sind A und D verschieden. Für den Fall, dass A und D gleich sind ist x=0. Erfindungsgemäß werden vorzugsweise solche Molenbrüche verwendet, welche für Schmelze und Kristall gleich sind, das heisst, solche Molenbrüche bei denen sich die prozentuale Zusammensetzung beim Auskristallisieren nicht ändert. Sofern erfindungsgemäße optische Elemente hergestellt werden sollen, welche eine Zusammensetzung aufweisen, in der sich das Material in einer anderen Zusammensetzung auskristallisiert als derjenigen der Schmelze, dann ist es erfindungsgemäß selbstverständlich ohne weiteres möglich durch laufende Zugabe des in der Schmelze abgereicherten Bestandteiles, deren prozentuale Zusammensetzung, und damit den Molenbruch im festen Kristall über die gesamte Zucht konstant zu halten.

Die erfindungsgemäßen optischen Elemente weisen insbesondere Absorptionskanten von <180 nm, insbesondere <175 nm, wobei Kanten von <170 nm und <165 nm besonders bevorzugt sind. In einzelnen Fällen ist mittels der erfindungsgemäßen Dotierung eine Verschiebung der Absorptionskante bis in den Bereich von 160 nm möglich.

Von den kubischen Spinellen haben sich insbesonders Spinell $MgAl_2O_4$, Ghanospinell $(Mg, Zn)Al_2O_4$, $CaAl_2O_4$, $CaB_2O_4$ und/oder Lithiumspinell $LiAl_5O_8$ als besonders geeignet erwiesen.

Von den kubischen Perovskiten sind $BaZrO_3$ und/oder $CaCeO_3$ besonders bevorzugt und von den kubischen II/VI-Oxiden sind insbesondere (Mg,Zn)O geeignet.

Es hat sich gezeigt, dass mit derartigen Materialien sich optische Elemente herstellen lassen, mit denen die eingangs genannten Anforderungen erreicht werden können. Derartige optische Elemente sind insbesondere solche, welche in einem Strahlengang elektromagnetische Wellen in einer vorgegebenen Weise umlenken bzw. in eine bestimmte Richtung leiten oder auch bündeln. Derartige elektromagnetische Wellen sind insbesondere Wellen im UV-, speziell im DUV-Bereich und weisen eine Wellenlänge von vorzugsweise kleiner 200 nm auf. Besonders bevorzugt ist Laserlicht, wobei hier ArF-Laser mit 193 nm und $F_2$-Laser mit 157 nm ganz besonders bevorzugt sind.

Derartige optische Elemente sind insbesondere Optiken, wie sie für Beleuchtungs- und Projektionssysteme in Lithographiescannern oder -steppern verwendet werden. Als Beleuchtungssystem wird dabei das im Strahlengang nach der Beleuchtungssquelle und vor der Photomaske angeordnete Linsensystem bezeichnet, als Projektionssystem wird das im Strahlengang nach der Photomaske d.h. zwischen Photomaske und den Wafer angeordnete Linsensystem bezeichnet.

Optische Elemente sind insbesondere Linsen oder Prismen. In einer bevorzugten Ausführung werden sie als endständige Linsen, d. h. als Frontlinsen in einer Projektionsoptik angeordnet, wobei optische Systeme, die zur Immersion geeignet sind ganz besonders bevorzugt sind.

Gemäß einer Ausführungsform weist das Linsensystem vorzugsweise mindestens zwei Linsen aus einem Material auf, welches aus kubischen Granaten, kubischen Spinellen, kubischen Perovskiten und/oder kubischen II/IV-Oxiden ausgewählt ist. Vorzugsweise sind in räumlicher Nähe zueinander im Linsensystem angeordnet und/oder so angeordnet, dass ihre relative Kristallorientierung zur Reduktion der Polariationseffekte aufgrund intrinsischer Doppelbrechung ausgelegt ist bzw. dass in Summe eine minimale Aberration aufgrund der intrinsischen Doppelbrechung entsteht. Beispielsweise können zwei Linsen aus dem gleichen Material azimutal so verdreht angeordnet werden, dass die intrinsische Doppelbrechung des Gesamtsystems minimiert wird, beispielsweise um ca. 25% reduziert wird.

Gemäß einer weiteren Ausführungsform enthält das Linsensystem neben mindestens eine erste Linse aus einem Material, welches aus kubischen Granaten, kubischen Spinellen, kubischen Perovskiten und/oder kubischen II/IV-Oxiden ausgewählt ist und dessen intrinsische Doppelbrechung ein bestimmtes Vorzeichen hat, mindestens eine weitere Linse aus einem zweiten Kristallmaterial, welches eine intrinische Doppelbrechung mit dem entgegengesetzten Vorzeichen aufweist. Ein solches zweites Kristallmaterial sollte vorzugsweise eine intrinsische Doppelbrechung mit einem Betrag von mindestens 3 nm/cm und entgegengesetztem Vorzeichen aufweisen. Eine oder mehrere Linsen aus einem solchen zweiten Kristallmaterial können dann hinsichtlich der Kristallorientierung relativ zur Kristallorientierung der ersten Linse im Linsensystem so angeordnet werden, dass die Aberration für das Linsensystem herabgesetzt wird. Als zweites Kristallmaterial eignet sich ebenfalls ein Material, welches aus kubischen Granaten, kubischen Spinellen, kubischen Perovskiten und/oder kubischen II/IV-Oxiden ausgewählt ist, sich aber von dem ersten Kristallmaterial unterscheidet. Ein solches zweites Kristallmaterial kann aber auch aus der Gruppe bestehend aus Erdalkalifluoriden, wie $CaF_2$, $SrF_2$ und/oder $BaF_2$, deren Mischkristalle der allgemeinen Formel $A_xB_{1-x}F_2$ und $Ba_x$-$Ca_{1-x}F_2$ mit A, B = Ca, Ba, Sr und $0 \leq x \leq 1$ oder Erdalkalioxide wie MgO, CaO, SrO und BaO ausgewählt sein. Beispielsweise kann die eine intrinsische Doppelbrechung einer Linse aus LuAG von ca. +30 nm/ cm durch eine oder mehrere Linsen aus $CaF_2$, das eine intrinsischen Doppelbrechung von ca. -3,4 nm/ cm aufweist, kompensiert werden. Durch geeignete Linsenkombination kann so eine intrinsische Doppelbrechung für das gesamte Linsensystem, beispielsweise ein Beleuchtungs- oder Projektionssystem, von unter 1 nm /cm realisiert werden.

Ferner können weiter eine oder mehrere Linsen aus beispielsweise Calciumfluorid im Linsensystem angeordnet sein, um weitere optische Fehler, beispielsweise Polarisationseffekte aufgrund der intrinsischen Doppelbrechung des/ der optischen Elemente aus kubischen Granaten, kubischen Spinellen, kubischen Perovskiten und/oder kubischen II/IV-Oxiden zu korrigieren.

Bevorzugte Immersionsflüssigkeiten sind Wasser, dotiertes Wasser, z. B. mit Fluorzusatz etc. Dabei lassen sich Brechwerte von 1,4 bis 1,5 sowie darüber einstellen. Vorzugsweise weist eine solche Immersionsflüssigkeit einen Brechwert von > 1,5 auf. Diese Flüssigkeiten sind UV-durchlässig und weisen einen ähnlichen oder gleichen Brechungsindex auf wie der zu belichtende Fotolack. Vorzugsweise weisen sie einen Brechungsindex auf, der maximal $\pm$ 0,3, insbesonders maximal $\pm$ 0,2, von demjenigen des Fotolackes abweicht. Der Brechungsindex der Linse soll vorzugsweise mindestens 0,1, insbesonders mindestens 0,15 und vorzugsweise mindestens 0,2 größer sein als derjenige der Flüssigkeit bzw. des Fotolackes. Auf diese Weise ist es möglich, Polarisationseffekte zu vermeiden und die numerische Apertur und damit die Auflösung bzw. Abbildungsgenauigkeit der Optik zu erhöhen.

Es hat sich insbesonders gezeigt, dass sich mit den beanspruchten Materialien aus einer Schmelze großvolumige Einkristalle herstellen lassen, welche die geforderten Dimensionen aufweisen, d. h. einen Durchmesser von größer 150 mm, insbesonders größer 200 mm, wobei Größen von 250 und insbesonders 300 mm besonders bevorzugt sind. Entsprechende Höhen von 100, insbesonders 150 und 200 bzw. 250 mm sind ebenfalls problemlos herstellbar. Vorzugsweise weisen derartige Kristalle bei einer Wellenlänge von 193 nm eine Spannungsdoppelbrechung auf, die kleiner 1 nm/cm ist, haben einen Brechungsindex von größer 1,6, vorzugsweise größer 1,8 und/oder zeigen eine Homogenität $\Delta$n von kleiner 1 ppm. Darüber hinaus sind sie vorzugsweise frei von Schlieren und zeigen eine intrinsische Doppelbrechung IDB bei 193 nm, deren Betrag kleiner gleich 35 nm/ cm, vorzugsweise kleiner gleich 30 nm/ cm, am meisten bevorzugt kleiner gleich 20 nm/cm ist. Die IDB kann beispielsweise durch den Einbau von Fremddionen in das Kristallgitter kompensiert werden, die eine IDB in entgegengesetzter Richtung erzeugen. Darüber hinaus sollen die verwendeten Kristallmaterialien eine elektronische Bandlücke $E_{gap}$ größer, vorzugsweise deutlich größer als 6,5 eV aufweisen. Ferner sollten sie bei 193 nm einen niedrigen dekadischen Absorptionskoeffizienten von vorzugsweise kleiner gleich $4 \times 10^{-2}$ cm$^{-1}$, mehr bevorzugt kleiner gleich $2 \times 10^{-2}$ cm$^{-1}$ aufweisen. Die intrinsische Bandkante des Materials sollte bei einer Wellenlänge von kleiner 190 nm, vorzugsweise von kleiner 185 nm liegen.

Die durch die erfindungsgemäße Verwendung hergestellten optischen Elemente sowie optischen Abbildungssysteme sind zur Herstellung von Steppern, Lasern, insbesondere von Excimer-Lasern, Computerchips, sowie integrierten Schaltungen und elektronischen Geräten, die solche Schaltungen und Chips enthalten, geeignet.

Beispiel

Es wurde Lu$_3$Al$_5$O$_{12}$-Kristall über das Czochralski-Verfahren hergestellt.

Die Kristalle wiesen bei 193 nm einen Brechungsindex von 2,04 nm und eine intrinsische Doppelbrechung von 30 ($\pm$2) nm/cm auf. Die intrinsische Bandkante liegt bei einer Wellenlänge von etwa 180 nm. Die spannungsinduzierte Doppelbrechung (SDB) im "as-grown"-Zustand beträgt kleiner 1 nm/ cm.

**Patentansprüche**

1. Verwendung von kubischen Granaten, kubischen Spinellen, kubischen Perovskiten und kubischen M(II)- sowie M(IV)-Oxiden zur Herstellung von optischen Elementen für die ultraviolette Strahlung.

2. Verwendung nach Anspruch 1, **dadurch gekennzeichnet, dass** die kubischen Granate Y$_3$Al$_5$O$_{12}$, Lu$_3$Al$_5$O$_{12}$, Ca$_3$Al$_2$Si$_3$O$_{12}$, K$_2$NaAlF$_6$, K$_2$NaScF$_6$, K$_2$LiAlF$_6$ und/oder Na$_3$Al$_2$Li$_3$F$_{12}$ sind.

3. Verwendung nach Anspruch 1 oder 2, **dadurch gekennzeichnet, dass** der kubische Granat die allgemeine Formel (A$_{1-x}$D$_x$)$_3$Al$_2$O$_{12}$ aufweist, wobei A und D gleich oder verschieden sein können und Ce, Pr, Nd, Pm, Sm, Eu, Gd, Tb, Dy, Ho, Er, Tm, Yb, Lu, Y und/oder Sc bedeuten und $0 \leq x \leq 1$ ist.

4. Verwendung nach Anspruch 1, **dadurch gekennzeichnet, dass** die kubischen Spinelle (Mg, Zn) Al$_2$O$_4$, CaAl$_2$O$_4$, CaB$_2$O$_4$ und/oder LiAl$_5$O$_8$ sind.

5. Verwendung nach Anspruch 1, **dadurch gekennzeichnet, dass** die kubischen II/VI-Oxide MgO und/oder (Mg,Zn)O sind.

6. Verwendung nach einem der vorhergehenden Ansprüche, **dadurch gekennzeichnet, dass** das optische Element eine Linse, Prisma, Lichtleitstab, optisches Fenster, eine optische Komponente für die DUV-Fotolithografie und/oder eine Frontlinse ist.

7. Verwendung nach Anspruch 1, **dadurch gekennzeichnet, dass** das optische Element eine Frontlinse in einer Immersionsoptik für die Mikrolithographie ist.

8. Optisches Element in einem Linsensystem für die Mikrolithographie, **dadurch gekennzeichnet, dass** es aus kubischen Granaten, kubischen Spinellen, kubischen Perovskiten und kubischen M(II)- sowie M(IV)-Oxiden gebildet ist.

9. Linsensystem für die UV-Mikrolithographie, **dadurch gekennzeichnet, dass** es mindestens ein optisches Element enthält, das aus kubischen Granaten, kubischen Spinellen, kubischen Perovskiten und kubischen M(II)- sowie M(IV)-Oxiden gebildet ist.

10. Linsensystem nach Anspruch 9, **dadurch gekennzeichnet, dass** ein optisches Element, das aus kubischen Granaten, kubischen Spinellen, kubischen Perovskiten und kubischen M(II)- sowie M(IV)-Oxiden gebildet ist, eine Frontlinse ist.

11. Linsensystem nach Anspruch 9 oder 10, **dadurch gekennzeichnet, dass** es mindestens zwei optische Elemente enthält, die aus kubischen Granaten, kubischen Spinellen, kubischen Perovskiten und kubischen M(II)- sowie M(IV)-Oxiden gebildet sind.

12. Linsensystem nach einem der Ansprüche 9 bis 11, **dadurch gekennzeichnet, dass** es mindestens ein optisches Element aus Calciumfluorid enthält.

13. Linsensystem nach einem der Ansprüche 9 bis 12, **dadurch gekennzeichnet, dass** es ein Projektionssystem ist.

14. Linsensystem nach einem der Ansprüche 9 bis 13, **dadurch gekennzeichnet, dass** es eine Immersionsoptik für Wellenlängen unter 200 nm ist.

15. Verwendung des optischen Elements nach Anspruch 8 und/oder des Linsensystems nach einem der Ansprüche 9 bis 14 zur Herstellung von Steppern, Lasern, insbesondere von Excimer-Lasern, Computerchips, sowie integrierten Schaltungen und elektronischen Geräten, die solche Schaltungen und Chips enthalten.

Europäisches
Patentamt

European
Patent Office

Office européen
des brevets

**EUROPÄISCHER RECHERCHENBERICHT**

Nummer der Anmeldung

EP 10 01 2478

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | BURNETT J H ET AL: "HIGH INDEX MATERIALS FOR 193 NM IMMERSION LITHOGRAPHY", PROCEEDINGS OF THE SPIE; CONFERENCE: OPTICAL MICROLITHOGRAPHY XVIII, SAN JOSE, CA, USA; CONFERENCE DATE: 1 MARCH 2005, Bd. 5754, Mai 2004 (2004-05), Seiten 611-621, XP009051940, BELLINGHAM, VA, US * Zusammenfassung * * Seite 615 - Seite 616 * * Seite 620 * ----- | 1-15 | INV. G02B1/02 G02B13/14 C30B29/22 C30B29/28 G03F7/20 |
| X,D | BURNETT J H ET AL: "HIGH INDEX MATERIALS FOR 193 NM AND 157 NM IMMERSION LITHOGRAPHY", INTERNATIONAL SYMPOSIUM ON IMMERSION & 157 NM LITHOGRAPHY, [POWERPOINT PRESENTATION], [Online] 8. Februar 2004 (2004-02-08), XP001207229, VANCOUVER, CANADA Gefunden im Internet: URL:http://www.sematech.org/resources/lith o/meetings/immersion/20040803/DAY_1_presen tations/1-11_NIST_Burnett.pdf> [gefunden am 2006-04-07] * das ganze Dokument * ----- | 1-15 | |
| X | PATENT ABSTRACTS OF JAPAN Bd. 2000, Nr. 26, 1. Juli 2002 (2002-07-01) -& JP 2001, 253716, A, (NATL INST OF ADVANCED INDUSTRIAL SCIENCE & TECHNOLOGY METI), 18. September 2001 (2001-09-18) * Zusammenfassung * ----- -/-- | 1 | RECHERCHIERTE SACHGEBIETE (IPC) G02B C30B G03F |

Der vorliegende Recherchenbericht wurde für alle Patentansprüche erstellt

| Recherchenort | Abschlußdatum der Recherche | Prüfer |
|---|---|---|
| München | 1. Dezember 2010 | Ward, Seamus |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus anderen Gründen angeführtes Dokument

..............................................................................................

& : Mitglied der gleichen Patentfamilie, übereinstimmendes
Dokument

EPO FORM 1503 03.82 (P04C03)

Europäisches
Patentamt

European
Patent Office

Office européen
des brevets

**EUROPÄISCHER RECHERCHENBERICHT**

Nummer der Anmeldung

EP 10 01 2478

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | EP 1 130 419 A (CANON KABUSHIKI KAISHA) 5. September 2001 (2001-09-05) * Zusammenfassung; Abbildungen * ----- | 1-15 | |
| A | NISHIMATSU T ET AL: "BAND STRUCTURES OF PEROVSKITE-LIKE FLUORIDES FOR VACUUM-ULTRAVIOLET-TRANSPARENT LENS MATERIALS", JAPANESE JOURNAL OF APPLIED PHYSICS, JAPAN SOCIETY OF APPLIED PHYSICS, TOKYO, JP, Bd. 41, Nr. 4A, PART 2, 1. April 2002 (2002-04-01), Seiten L365-L367, XP001168678, ISSN: 0021-4922 * Zusammenfassung * ----- | 1-15 | |

**RECHERCHIERTE SACHGEBIETE (IPC)**

Der vorliegende Recherchenbericht wurde für alle Patentansprüche erstellt

| Recherchenort | Abschlußdatum der Recherche | Prüfer |
|---|---|---|
| München | 1. Dezember 2010 | Ward, Seamus |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument

................................................................

& : Mitglied der gleichen Patentfamilie, übereinstimmendes
    Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 10 01 2478

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

01-12-2010

| Im Recherchenbericht angeführtes Patentdokument | Datum der Veröffentlichung | Mitglied(er) der Patentfamilie | Datum der Veröffentlichung |
|---|---|---|---|
| JP 2001253716 A | 18-09-2001 | KEINE | |
| EP 1130419 A | 05-09-2001 | JP 2001244188 A<br>US 2001053017 A1 | 07-09-2001<br>20-12-2001 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

**In der Beschreibung aufgeführte Nicht-Patentliteratur**

- **J. H. Burnett et al.** High Index Materials for 193 nm and 157 nm Immersion Lithography. *International Symposium on Immersion and 157 nm Lithography,* 02. August 2004